# EUROPEAN PATENT APPLICATION

(11) **EP 4 486 084 A1**
(43) Date of publication of application: **01.01.2025**
(21) Application number: 24180906.0
(22) Date of filing: 07.06.2024
(51) Int. Cl.: H05K 7/20

(54) **SERVER WITH HYBRID THERMAL MANAGEMENT SYSTEM**

(30) Priority: 09.06.2023 US 202363507228 P
(71) Applicant: Carrier Corporation, Palm Beach Gardens, FL 33418 (US)
(72) Inventor: JOARDAR, Arindom, Syracuse, 13221 (US); BUSHNELL, Peter, Syracuse, 13221 (US)
(74) Representative: Dehns

(57) **Abstract**

A cooling system (100) for cooling an assembly including at least one heat-generating electronic device (50) includes a heat spreader (120) thermally coupled to the at least one heat-generating electronic device (50) and a heat removal device (102) having a surface (128) that is thermally coupled to the at least one heat-generating electronic device (50) via the heat spreader (120). The heat removal device (102) includes an inlet area (106) and at least one jet impingement feature (110) fluidly coupled to the inlet area (106). The at least one jet impingement feature (110) is positioned to direct a primary cooling fluid (C1) toward the surface (128) that is thermally coupled to the at least one heat-generating electronic device (50).

## Description

### BACKGROUND

Exemplary embodiments pertain to the art of thermal management, and more particularly, relate to thermal management of a server within a data center.

A "data center" refers to the physical location of one or more servers. A data center and the servers housed within a data center typically consume a significant amount of electrical power. Existing servers are designed to be cooled at least partially by a flow of air. Such servers usually include one or more printed circuit boards having a plurality of operable heat-generating devices mounted thereto. The printed circuit boards are commonly housed in an enclosure having vents configured to direct external air from the data center into, through and out of the enclosure. The air absorbs heat dissipated by the components and after being exhausting from the enclosure, mixes with the ambient air. An air conditioner is then used to cool the heated air of the data center and to recirculate it, repeating the cooling process.

Higher performance server components typically dissipate more power. However, the amount of heat that conventional cooling system can remove from a server is in part limited by the extent of the air conditioning available from the data center. In general, a lower air temperature in a data center allows each server component cooled by an air flow to dissipate a higher power, and thus allows each server to operate at a correspondingly higher level of performance.

### BRIEF DESCRIPTION

According to an embodiment, a cooling system for cooling an assembly including at least one heat-generating electronic device includes a heat spreader thermally coupled to the at least one heat-generating electronic device and a heat removal device having a surface that is thermally coupled to the at least one heat-generating electronic device via the heat spreader. The heat removal device includes an inlet area and at least one jet impingement feature fluidly coupled to the inlet area. The at least one jet impingement feature is positioned to direct a primary cooling fluid toward the surface that is thermally coupled to the at least one heat-generating electronic device.

In addition to any one or more of the features described herein, further embodiments may include the heat removal device including a heat exchanger having an outlet header. The surface that is thermally coupled to the at least one heat-generating electronic device may be arranged within the outlet header. The primary cooling fluid and a secondary cooling fluid may be arranged in a heat transfer relationship within the at least one heat exchanger.

In addition to any one or more of the features described herein, further embodiments may include the heat exchanger having and inlet header and the inlet area is defined by the inlet header. A plurality of heat exchange tubes may extend between the inlet header and the outlet header. The at least one jet impingement feature may be separate from and fluidly coupled to the plurality of heat exchange tubes.

In addition to any one or more of the features described herein, further embodiments may include the heat exchanger having and inlet header and the inlet area is defined by the inlet header. A plurality of heat exchange tubes may extend between the inlet header and the outlet header. The at least one jet impingement feature may be integral with at least one of the plurality of heat exchange tubes.

In addition to any one or more of the features described herein, further embodiments may include a fluid movement device operable to move the secondary cooling fluid through the heat removal device.

In addition to any one or more of the features described herein, further embodiments may include the fluid movement device being a fan and the secondary cooling fluid being air.

In addition to any one or more of the features described herein, further embodiments may include the heat removal device including a plurality of heat exchangers and each of the plurality of heat exchangers being located at and thermally coupled to a respective heat-generating electronic device.

In addition to any one or more of the features described herein, further embodiments may include at least some of the plurality of heat exchangers being arranged in series relative to a flow of the primary cooling fluid.

In addition to any one or more of the features described herein, further embodiments may include at least some of the plurality of heat exchangers being arranged in parallel relative to a flow of the primary cooling fluid.

In addition to any one or more of the features described herein, further embodiments may include a secondary heat exchanger located upstream from the heat removal device relative to a flow of the primary cooling fluid.

In addition to any one or more of the features described herein, further embodiments may include the secondary heat exchanger being arranged upstream from the heat removal device relative to a flow of the secondary cooling fluid.

In addition to any one or more of the features described herein, further embodiments may include the primary cooling fluid being provided to the heat removal device is a single phase liquid.

According to another embodiment, a method of cooling an assembly including at least one heat-generating electronic device and at least one peripheral heat-generating device includes cooling a secondary cooling fluid via a primary cooling fluid, flowing the cooled secondary cooling fluid over the at least one peripheral heat-generating device, and expelling the primary cooling fluid at a surface of a heat removal device thermally coupled to the at least one heat-generating electronic device via at least one jet impingement feature to cool the at least one heat-generating electronic device.

In addition to any one or more of the features described herein, further embodiments may include the heat removal device being a heat exchanger and cooling the secondary cooling fluid via the primary cooling fluid may occur within a plurality of heat exchanger tubes of the heat exchanger.

In addition to any one or more of the features described herein, further embodiments may include providing the secondary cooling fluid to the heat exchanger via a fluid movement device.

In addition to any one or more of the features described herein, further embodiments may include providing the primary cooling fluid to a secondary heat exchanger, the secondary heat exchanger being located upstream from the heat exchanger relative to a flow of the primary cooling fluid.

In addition to any one or more of the features described herein, further embodiments may include cooling the primary cooling fluid within the secondary heat exchanger.

In addition to any one or more of the features described herein, further embodiments may include providing the primary cooling fluid to another heat removal device located at and thermally coupled to the at least one heat-generating electronic device. The another heat removal device may be arranged downstream from and in series with the heat removal device relative to a flow of the primary cooling fluid.

In addition to any one or more of the features described herein, further embodiments may include providing the primary cooling fluid to another heat removal device located at and thermally coupled to the at least one heat-generating electronic device. The another heat removal device may be arranged in parallel with the heat removal device relative to a flow of the primary cooling fluid.

### BRIEF DESCRIPTION OF THE DRAWINGS

The following descriptions are provided by way of example only and should not be considered limiting in any way on the scope of the invention. With reference to the accompanying drawings, like elements are numbered alike:
FIG. 1 is a front view of a data center rack having a plurality of servers mounted therein;
FIG. 2 is a perspective view of a server;
FIG. 3A is a top view of a server;
FIG. 3B is a cross-sectional side view of the server of FIG. 3A;
FIG. 4 is a cross-sectional view of a heat exchanger of a cooling system suitable for use with the server;
FIG. 5 is a cross-sectional view of a heat spreader having an integral fluid circuit;
FIG. 6A is a schematic diagram of a circuit of the primary cooling fluid of a cooling system;
FIG. 6B is a schematic diagram of a circuit of the primary cooling fluid of a cooling system;
FIG. 7 is a schematic diagram of a portion of a circuit of the primary cooling fluid of a cooling system;
FIG. 8 is a schematic diagram of a portion of a circuit of the primary cooling fluid of another cooling system;
FIG. 9 is a schematic diagram of a portion of a circuit of the primary cooling fluid of yet another cooling system; and
FIG. 10 is a schematic diagram of a heat removal device of a cooling system suitable for use with the server.

### DETAILED DESCRIPTION

A detailed description of one or more embodiments of the disclosed apparatus and method are presented herein by way of exemplification and not limitation with reference to the Figures.

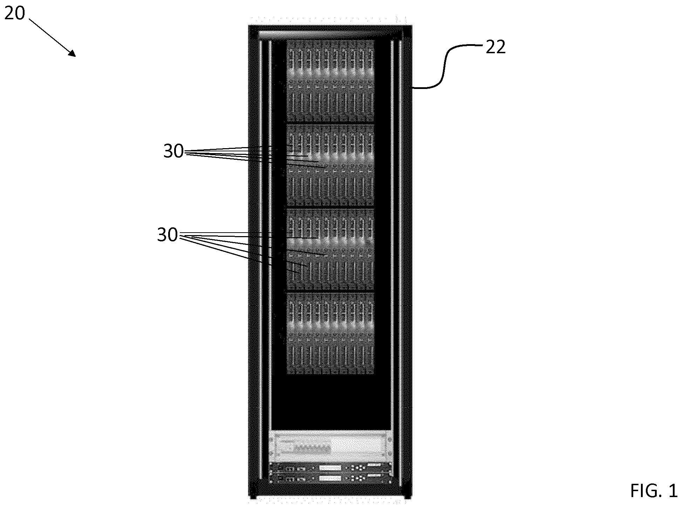

With reference now to FIG. 1, an example of a data center 20 is illustrated. As shown, the data center 20 includes a cabinet 22 having at least one, and in some embodiments, a plurality of slots (not shown) formed therein. One or more server rack sub-assemblies, also referred to herein as servers 30 may be permanently or removably mountable within the cabinet 22, such as within the one or more slots formed therein. The plurality of slots, and therefore the at least one server 30 receivable therein, may have a generally vertical orientation (shown), or alternatively, may have a horizontal orientation. In some embodiments, the data center 20 may include a combination of both horizontally oriented and vertically oriented slots. Further, although only a single cabinet 22 is illustrated in the FIG., it should be appreciated that the data center 20 may include several cabinets 22. In embodiments including a plurality of cabinets 22, the plurality of cabinets 22 may be arranged at the same location within a building, or alternatively, one or more of the cabinets 22 may be arranged at a different location within a single building or within multiple buildings.

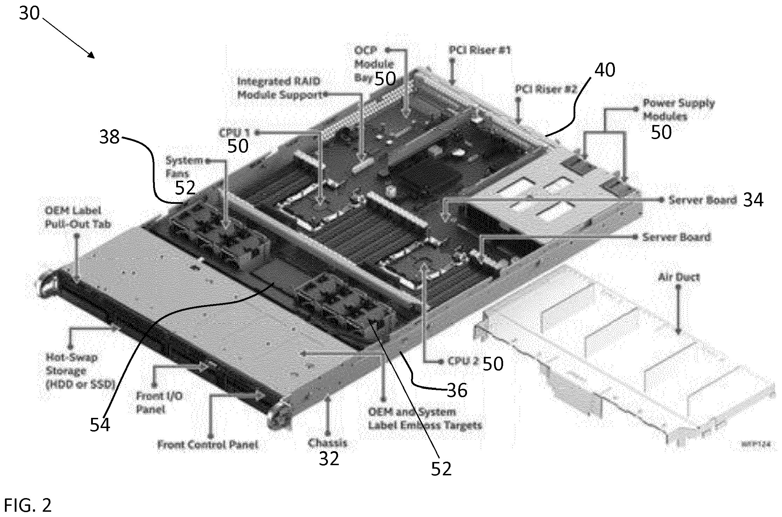

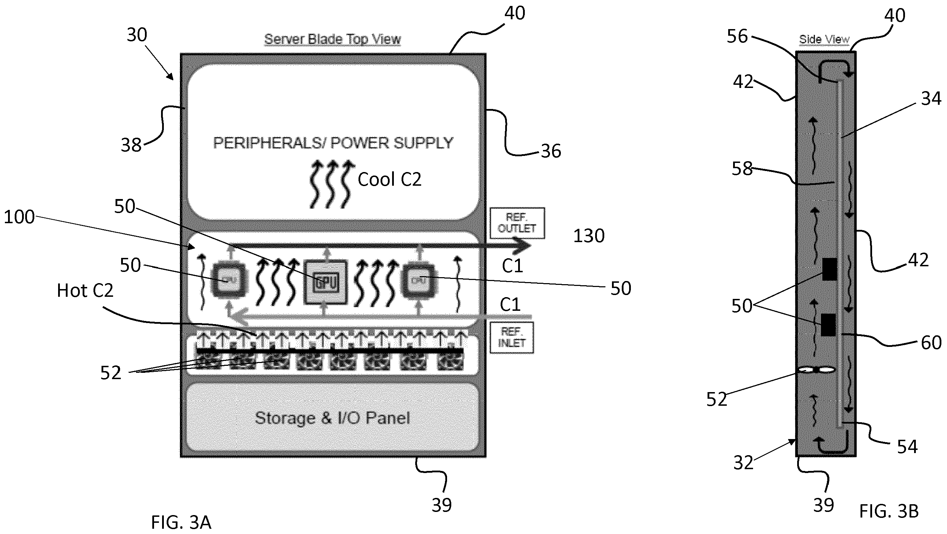

With reference now to FIGS. 2 and 3A, an example of a server 30 receivable within a slot of the cabinet 22 is illustrated. As shown, the server 30 may include a frame or chassis 32 having at least one printed circuit board 34 mounted to the frame. Although only a single printed circuit board 34 is illustrated in the FIG., it should be understood that in some embodiments, a plurality of printed circuit boards may be mounted to the chassis 32. The chassis 32 is designed to be insertable, for example slidably insertable, into a slot of a server rack and allow for connection to power cables, data cables, and/or other connecting cables provided at or by the cabinet 22.

The chassis 32 may include a plurality of walls 36, 38, 39, and 40 oriented at an angle to the printed circuit board 34 and that extend about all or at least a portion of a periphery of the printed circuit board 34. In an embodiment, the chassis 32 includes at least one flat, generally planar panel connected to one or more of the peripheral walls 36, 38, 40 of the chassis 32. The at least one flat panel 42 may be arranged at either a first side or a second side of the printed circuit board 34. When the server 30 is in a horizontal orientation as shown, such a flat panel 42 may be vertically offset from the printed circuit board 34, either above or underneath the printed circuit board. In some embodiments, best shown in FIG. 3B, a flat panel 42 may be arranged both above and below the printed circuit board. In an embodiment, the chassis 32 in combination with the flat panels 42 form an air-tight container surrounding the server 30. However, embodiments where a separate jacket or container is positioned about the server 30 to form an air-tight assembly are also contemplated herein. Additionally, embodiments involving air exchanges with ambient are also within the scope wherein ambient air is drawn into the server which extracts heat from the heat generating components and is then discharged out with or without thermal management.

At least one heat-generating electronic device 50 may be mounted or electrically connected to the printed circuit board 34. Examples of a heat-generating electronic device 50 include but are not limited to a processor such as a central processing unit and/or graphics processing unit, a memory, a hard drive, and a power supply module. A server 30 may also include one or more components that are not mounted to or are not electrically connected to the printed circuit board 34. In embodiments where the server 30 includes two or more of the same type of component, such as central processing units for example, the components may be aligned along an axis extending between the lateral sides 36, 38 of the chassis 32, may be aligned along an axis extending between the front and back of the chassis 32, or may be offset from one another in one or more directions. It should be appreciated that any heat-generating electronic device 50 may be located at any position within the chassis 32 or about the circuit board 34.

In an embodiment, one or more fluid movement devices 52 are mounted to the printed circuit board 34 and are operable to move a flow of a fluid, such as air over the heat-generating electronic devices 50. In the illustrated, non-limiting embodiment, the at least one fluid movement device is a fan 52 arranged near a first end 54 of the printed circuit board 34 such that when the server 30 is installed within the cabinet 22 the at least one fan 52 is positioned closer to the front of the cabinet 22 than the heat-generating electronic devices 50. However, embodiments where one or more fluid movement devices 52 are arranged at another suitable location, such as near a second end 56 of the printed circuit board 34 or of the chassis 32 associated with the rear of the cabinet 22 for example, are also within the scope of the disclosure. It should be appreciated that a server 30 having any suitable configuration, including servers having a full width or a half width or sled configuration are within the scope of the disclosure.

In an embodiment, the fluid moved by the at least one fluid movement devices 52 is configured to make a single pass over the heat-generating electronic devices 50. For example, cool air may be drawn into a fan 52 from a location adjacent to the front of the chassis 32 and after removing heat from the heat-generating electronic devices 50, may be exhausted at the back of the chassis 32. It should be appreciated that the air exhausted from the back of the cabinet 22 may be the same temperature as the surrounding environment, warmer than the surrounding environment, or even cooler than the surrounding environment. In other embodiments, such as where the chassis 32 includes at least one flat panel 42 for example, the fluid may be configured to continuously circulate within the server 30. For example, as best shown in FIG. 3B, a fluid movement device 52 may push the flow of fluid across the heat-generating electronic devices 50 arranged at a first surface 58 of the printed circuit board 34. Upon reaching the second end 56 of the printed circuit board 34, the fluid may turn through one or more openings and make a second pass along the second, opposite surface 60 of the printed circuit board 34. Upon reaching the first end 54 of the printed circuit board 34, the fluid may turn again, and be drawn back into an inlet of the at least one fluid movement device 52.

The server 30 may include a cooling system 100 for removing heat from one or more of the heat-generating electronic devices 50. In an embodiment, the cooling system 100 is operable to cool at least one heat-generating electronic device 50 using a primary cooling fluid C1. The other heat-generating electronic devices 50 mounted to the printed circuit board 34 that are not directly cooled via the primary cooling fluid C1 may be considered "peripheral" heat-generating devices. Although in the illustrated, non-limiting embodiments, the selected heat-generating electronic device is described as a central processing unit or graphics processing unit and the at least one peripheral heat-generating device is described as including other components, such as memory, hard drive, or power supply module, it should be appreciated that any of the components of the server 30 may be designed as the at least one selected heat-generating electronic device directly cooled by the primary cooling fluid C1, and any of the components of the server 30 may be designed as a peripheral heat-generating device.

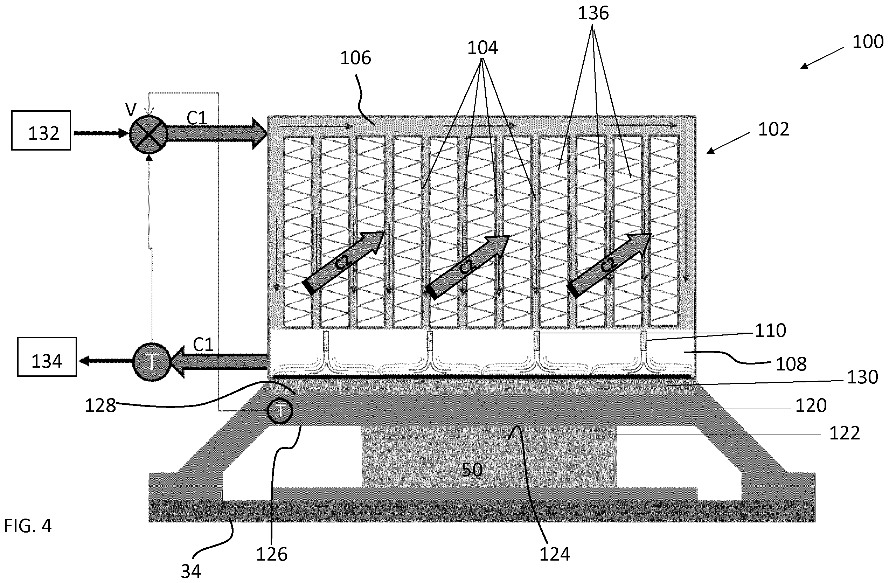

In an embodiment, the cooling system 100 includes a heat removal device 102, such as a heat exchanger for example, mounted in an axially overlapping relationship with and thermally coupled to at least one heat-generating electronic device. With reference to the cross-sectional view of the cooling system 100 shown in FIG. 4, the heat exchanger 102 may be a microchannel heat exchanger having a plurality of substantially parallel microchannel heat exchanger tubes 104 extending between an inlet header 106 and an outlet header 108, each of the plurality of heat exchanger tubes 104 defining a plurality of fluid flow paths (not shown). However, examples of other types of heat exchangers that may be used, include, but are not limited to, microtube, double pipe, shell and tube, tube and fin, plate, plate and shell, adiabatic shell, plate fin, pillow plate, and fluid heat exchangers. The type of heat exchanger 102 selected may depend at least in part based on the type of fluids being provided thereto.

A primary cooling fluid C1 and a secondary cooling fluid C2 are arranged in a heat transfer relationship at the heat exchanger 102. In the non-limiting embodiment illustrated in FIG. 4, the heat exchanger 102 has a single pass configuration for both the primary cooling fluid C1 and the secondary cooling fluid C2. However, in other embodiments, at least one of the primary and secondary cooling fluids C1, C2 may make multiple passes through the heat exchanger 102. Further, the primary and secondary cooling fluids C1, C2 may be arranged in any suitable flow configuration at the heat exchanger, such as a cross-flow, a parallel flow, a counter-flow, or any combination thereof.

In an embodiment, at least one jet impingement feature, such as a nozzle, jet, or orifice, hole, or opening formed in a plate 110, and in some embodiments a plurality of jet impingement features 110 are arranged within the outlet header 108 and each nozzle 110 is fluidly coupled to at least one fluid flow path of one or more heat exchanger tubes 104. An outlet end of the jet impingement features 110 is aimed at a surface of the outlet header 108 thermally coupled to at least one selected heat-generating electronic device 50, such as a bottom surface of the outlet header 108 for example. Although the one or more jet impingement features 110 are illustrated and described herein as being separate from the heat exchange tubes 104, in an embodiment, an outlet end of the heat exchange tubes 104 may be contoured such that one or more jet impingement features 110 are integral therewith. The jet impingement configurations may be a free surface type or submerged type or confined-submerged type. Furthermore, the jet issuing from the jet impingement features 110 may be of any geometrical shape in the cross-section such as circular, polygonal, star-shaped etc.

In some embodiments, the heat exchanger 102 is directly coupled to a surface of the at least one selected heat-generating electronic device 50. However, in other embodiments, as shown in FIG. 4, the heat exchanger 102 is indirectly coupled to the at least one selected heat-generating electronic device 50. In server applications, the surface area of the heat-generating electronic devices (i.e. CPUs, GPUs, etc.,) available is very small. Because the amount of heat to be dissipated from such a heat-generating device 50 is typically very high, the surface area available to form an interface with a heat removal device is in sufficient to meet the cooling demand of the heat-generating electronic device. Accordingly, in the illustrated, non-limiting embodiment, a heat spreader 120, such as formed from a conductive material like sheet metal for example, is affixed to the printed circuit board 34 adjacent to the selected heat-generating electronic device 50. Although the heat spreader 120 is illustrated as axially overlapping both the at least one selected heat-generating electronic device 50 and the printed circuit board 34, embodiments where the heat spreader 120 is arranged at another location relative to the at least one selected heat-generating electronic device 50 are also contemplated herein.

A thermal interface material 122 may be arranged between a surface 124 of the at least one selected heat-generating electronic device and an adjacent surface 126 of the heat spreader 120 to facilitate the transfer of heat from the at least one selected heat-generating electronic device 50 to the heat spreader 120. The surface area of the surface 126 of the heat spreader 120 facing the at least one selected heat-generating electronic device 50 may be greater than, equal to, or in some embodiments, may even be smaller than the surface area of the surface 124 of the at least one selected heat-generating electronic device 50.

The heat exchanger 102 is thermally coupled to a second, opposite surface 128 of the heat spreader 120. In an embodiment, the second, opposite surface 128 of the heat spreader 120 is greater than the surface 124 of the at least one selected heat-generating electronic device 50 to facilitate the transfer of heat from the heat spreader 120 to a fluid within the heat exchanger 102, such as the primary cooling fluid C1 for example. For example, the surface area of surface 128 of the heat spreader 120 may be at least 30% greater than that of the surface 124 of the at least one selected heat-generating electronic device 50, and in some embodiments, is at least 40%, 50%, 60%, 70%, 80%, 90%, 100%, or more than 100% greater than the surface 124 of the at least one selected heat-generating electronic device 50. However, in other embodiments, the surface area of the second surface 128 of the heat spreader 120 may be the same or even smaller than the surface area of the at least one selected heat-generating electronic device 50. In the illustrated, non-limiting embodiment, the outlet header 108 is positioned directly adjacent to the heat spreader 120 and may be thermally coupled thereto via a thermal interface material 130.

The inlet header 106 of the heat exchanger 102 may be fluidly connected to a first fluid inlet 132 and the outlet header 108 may be fluidly connected to a first fluid outlet 134 to form a first flow path of the primary cooling fluid C1. In operation, the primary cooling fluid C1, such as a refrigerant for example, is provided from the first fluid inlet 132 into the inlet header 106 of the heat exchanger 102. The primary cooling fluid C1 provided to the inlet header 106 may be a single phase, such as a cool or cold liquid for example. From the inlet header 106, the primary cooling fluid C 1 flows through the plurality of heat exchange tubes 104 of the heat exchanger 102 toward the outlet header 108.

A secondary cooling fluid C2 is configured to flow through the gaps 136 defined between adjacent heat exchanger tubes 104. In the illustrated, non-limiting embodiment, the secondary cooling fluid C2 is a flow of air moved (in a direction extending into the plane of the page) by the at least one fluid movement device 52 associated with the server 30. However, it should be understood that any fluid, including a liquid, may be used as the secondary cooling fluid. In the illustrated, non-limiting embodiment, a plurality of fins is arranged within the gaps 136 defined between adjacent heat exchanger tubes 104; however, embodiments that do not include such fins are also contemplated herein. Within the plurality of passages of the heat exchange tubes 104, heat from the secondary cooling fluid C2 is transferred to the primary cooling fluid C1. The resulting cooled secondary cooling fluid C2 provided at an outlet of the heat exchanger 102 may be configured to flow over the peripheral heat-generating devices of the server 30.

At least a portion of the now slightly warmer primary cooling fluid C1 is output from the plurality of heat exchange tubes 104 to the one or more jet impingement features 110 arranged within the outlet header 108. In an embodiment, the primary cooling fluid C1 may be a single phase when provided to the one or more jet impingement features 110. Within the jet impingement features 110, the flow rate of the primary cooling fluid C1 is increased such that the primary cooling fluid C1 is expelled from an outlet of the jet impingement features at a surface of the outlet header 108 vertically aligned with the selected heat-generating electronic device 50. At least a portion of the heat transferred to the first surface 126 of the heat spreader 120 from the at least one selected heat-generating electronic device 50 is transferred from the second surface 128 of the heat spreader 120 to the primary cooling fluid C1. The continuous impingement of the primary cooling fluid C1 on the surface of the outlet header 108 transfers heat from the surface of the outlet header 108 to the primary cooling fluid C1, thereby cooling the at least one selected heat-generating electronic device 50. After contacting the surface of the outlet manifold, the resulting warmer primary cooling fluid C1 then exits the outlet header 108 of the heat exchanger 102 and flows toward the first fluid outlet 134.

As best shown in FIG. 4, at least one valve may be arranged within the first fluid inlet 132 and/or the first fluid outlet 134 to control the flow of the primary cooling fluid C1 to and from the heat exchanger 102. In an embodiment, the position of the valve(s) V and therefore the flow through the heat exchanger 102, is actively managed based on a thermal load at the heat exchanger 102. The thermal load may be determined on information collected by one or more sensors, represented schematically at T. In the illustrated, non-limiting embodiment, a first sensor is operable to monitor the temperature of the heat spreader 120, and a second sensor is operable to monitor the temperature of the primary cooling fluid C1 at the outlet header 108. The at least one sensor T may be operable to measure temperature directly or may be configured to monitor another parameter that correlates to or can be used to derive temperature therefrom.

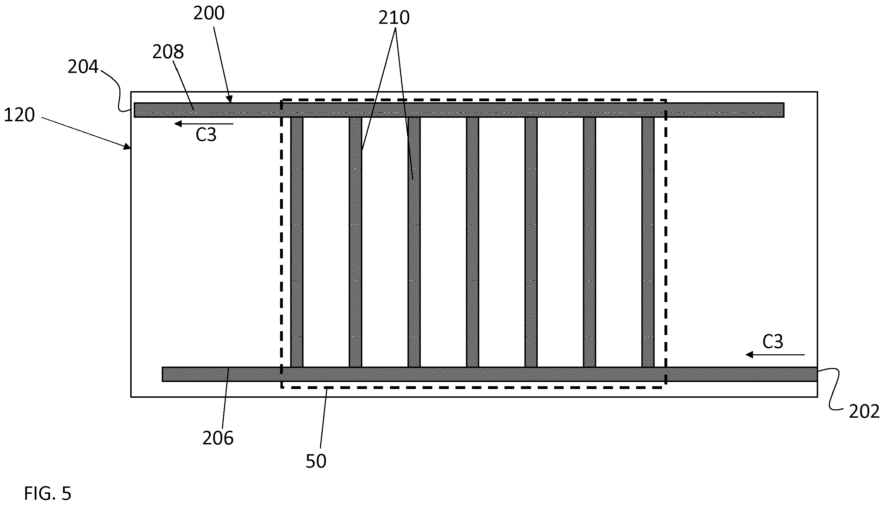

In an embodiment, the heat spreader 120 of the cooling system 100 is a cold plate having an internal fluid circuit. An example of an internal fluid circuit 200 of the heat spreader 120 is illustrated in the cross-sectional view of the heat spreader shown in FIG. 5. As shown, the fluid circuit 200 includes a fluid inlet 202 and a fluid outlet 204 formed in the body of the heat spreader 120. The fluid inlet 202 and the fluid outlet 204 can be any shape, such as in the depth dimension (e.g., in the z-x plane of the attached figure), including the shape of a circle, oval, triangular, square, rectangular, or any simple polygonal shape or portion thereof. Also, in an embodiment, the fluid outlet 204 can have a much larger diameter compared to the fluid inlet 202, thereby helping to reduce the pressure drop for the cooling medium passing through the fluid outlet 204.

In an embodiment, the fluid circuit includes a single continuous flow path extending between the fluid inlet 202 and the fluid outlet 204. However, in other embodiments, the fluid circuit 200 includes a first or inlet manifold 206, a second or outlet manifold 208, and at least one fluid passage 210 connecting the first and second manifolds 206, 208. In an embodiment, the at least one fluid passage 210 includes a plurality of fluid passages 210. The fluid inlet 202 can be configured to connect a source of a third cooling medium C3 to the inlet manifold 206 using any suitable mechanical connection. The third cooling medium C3 may be the same as either the primary cooling fluid C1 or the secondary cooling fluid C2 or may be distinct or different therefrom.

In an embodiment, one or more fluid passages 210 of the fluid circuit 200 may be positioned to perform localized cooling at the area of the heat spreader with the greatest heat flux, such as at the area of the heat spreader directly aligned with or in overlapping arrangement with a heat-generating electronic module. Accordingly, the at least one fluid passage 210 may be associated with a heat-generating electronic module 50. In embodiments where the heat spreader is associated with a plurality of heat-generating electronic modules, one or more fluid passages 210 may be associated with and configured to remove heat from a respective heat-generating electronic module. More specifically, the at least one fluid passage 210 associated with a respective heat-generating electronic module 50 may be physically located within the heat spreader 120 in alignment with the heat-generating electronic module 50. Inclusion of a fluid circuit 200 within the heat spreader 120 may reduce the size of the heat removal device 102 of the cooling system 100.

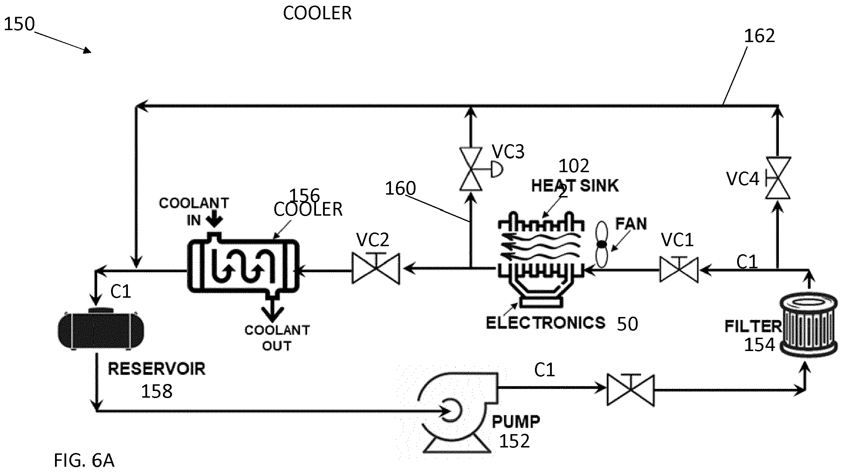

With reference now to FIG. 6A, an example of a circuit 150 of the primary cooling fluid C1 of the cooling system 100 is illustrated. In the illustrated, non-limiting embodiment, the circuit 150 of the primary cooling fluid C1 of the cooling system 100 is a closed loop and includes a pump 152 for moving the primary cooling fluid C1 therethrough. A filter 154 may be located upstream from the at least one heat removal device 102 positioned to directly cool a corresponding heat-generating electronic device 50. Downstream from the one or more heat removal devices 102 is a cooling heat exchanger 156 configured to remove heat from the primary cooling fluid C1. The circuit 150 may additionally include a reservoir or accumulator 158 within which excess primary cooling fluid C1 is stored. As shown, the circuit 150 may include a plurality of valves, such as arranged directly upstream from the heat removal device 102 (VC1), directly downstream from a heat exchanger 102 (VC2), associated with a bypass conduit 160 for bypassing the cooling heat exchanger 156 (VC3), and associated with another bypass conduit 162 for bypassing both the heat removal device 102 and the cooling heat exchanger 156 (VC4).

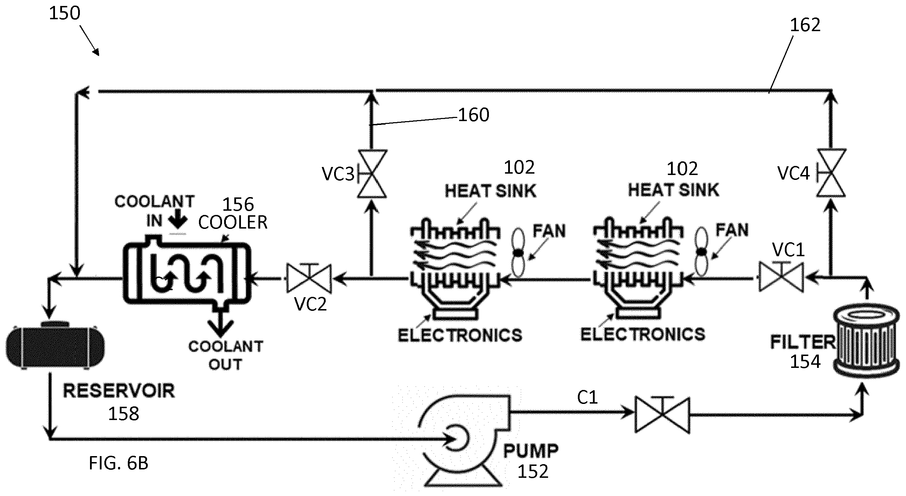

With reference now to FIG. 6B, another circuit, similar to the circuit of FIG. 6A is illustrated. However, the circuit shown in FIG. 6B includes a plurality of heat exchangers 102 arranged in series relative to the flow pf the primary cooling fluid C1. A fluid movement device 52 is diagrammatically illustrated as being associated with each respective heat removal device 102. It should be appreciated, that in an embodiment, each heat removal device 102 is configured to receive a flow of the secondary cooling fluid C2 from all of the fluid movement devices 52. However, embodiments where each heat removal device 102 is fluidly coupled and configured to receive a flow of the secondary cooling fluid C2 from a respective fluid movement device 52 is also contemplated herein.

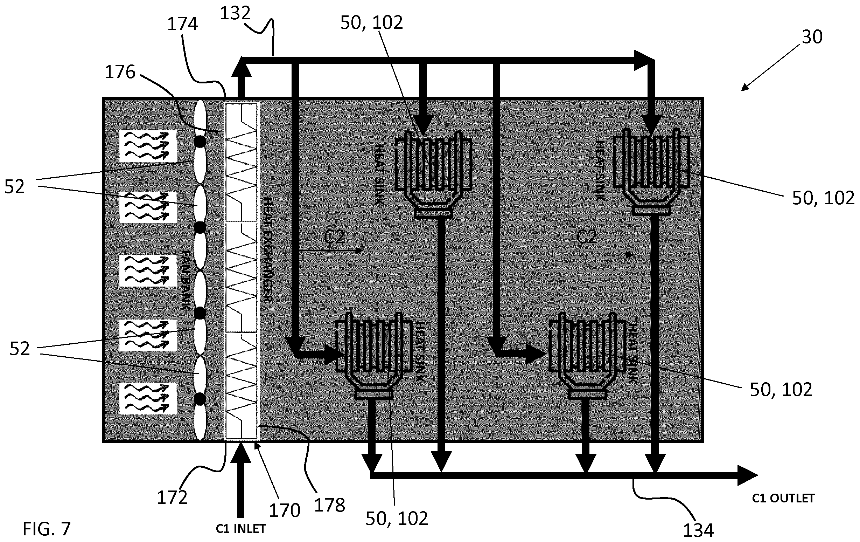

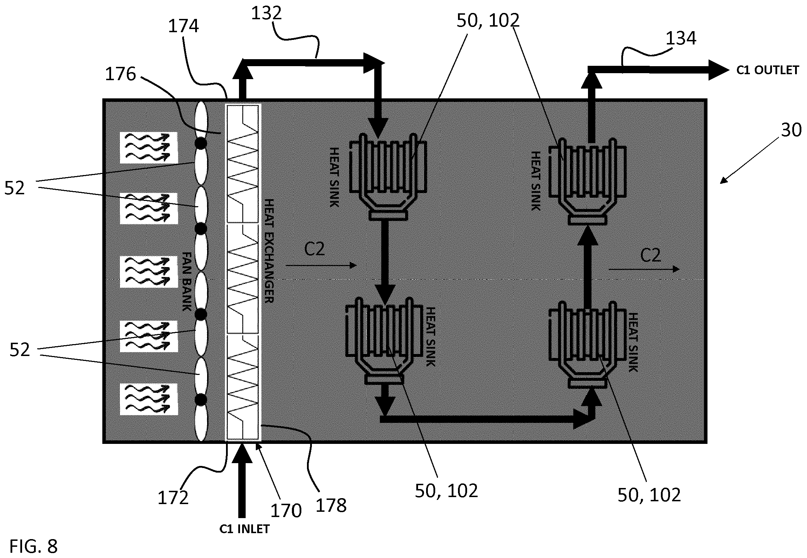

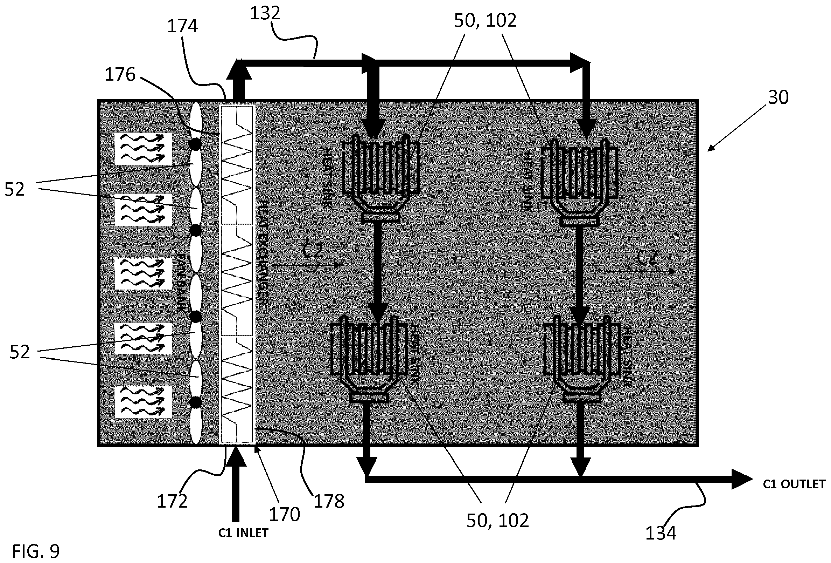

With reference to FIGS. 7-9, it can be appreciated that in some embodiments, the cooling system 100 may include a plurality of heat removal device 102, each positioned to directly cool a respective heat-generating electronic device 50. In such embodiments, the primary cooling fluid C1 may flow to the plurality of heat removal device 102 in any suitable manner. For example, as shown in FIG. 7, each of the plurality of heat exchangers 102 may be fluidly connected in parallel relative to a flow of the primary cooling fluid C1 between the first fluid inlet 132 and the first fluid outlet 134. In another embodiment, shown in FIG. 8, the plurality of heat removal devices 102 may be fluidly connected in series relative to a flow of the primary cooling fluid C1 between the first fluid inlet 132 and the first fluid outlet 134. In yet another embodiment, the plurality of heat removal devices 102 may be fluidly connected in both parallel and series relative to a flow of the primary cooling fluid C1 between the first fluid inlet 132 and the first fluid outlet 134. As shown, multiple flow paths extend between the first fluid inlet 132 and the first fluid outlet 134 and at least one of the flow paths, and in some embodiments each flow path, includes a plurality of heat exchangers 102.

As shown in FIGS. 7-9, in an embodiment, the cooling system 100 additionally includes a secondary heat exchanger 170 used to condition or cool another medium, such as the secondary cooling fluid C2 for example. The secondary heat exchanger 170 may be mounted to the chassis 32 and/or the printed circuit board 34 and is located remotely from both the one or more selected heat-generating electronic devices 50 and the one or more peripheral heat-generating devices. In the illustrated, non-limiting embodiments, the secondary heat exchanger 170 is located, upstream from the at least one heat removal device 102 mounted in overlapping arrangement with at least one selected heat-generating electronic device 50 relative to a flow of the primary cooling fluid C1, and in some embodiments relative to a flow of the secondary cooling fluid C2. For example, the secondary heat exchanger 170 may be mounted near a first end 54 of the printed circuit board 34, at a location between the at least one selected heat-generating electronic device 50 and the at least one fan 52. However, embodiments where the secondary heat exchanger 170 is arranged at another location are also contemplated herein.

The secondary heat exchanger 170 may be any suitable type of heat exchanger. In an embodiment, the secondary heat exchanger 170 is a microchannel heat exchanger having a plurality of substantially parallel microchannel heat exchanger tubes, each defining a plurality of fluid flow paths (not shown). However, examples of other types of heat exchangers that may be used, include, but are not limited to, microtube, double pipe, shell and tube, tube and fin, plate, plate and shell, adiabatic shell, plate fin, pillow plate, and fluid heat exchangers.

In the illustrated, non-limiting embodiments, the secondary heat exchanger 170 has a primary inlet 172 and a primary outlet 174 defining a flow path for the primary cooling fluid C1 and a secondary inlet 176 and a secondary outlet 178 defining a flow path for the secondary cooling fluid C2. The primary cooling fluid C1 and the secondary cooling fluid C2 may each make a single pass through the secondary heat exchanger 170. However, in other embodiments, at least one of the primary and secondary cooling fluids C1, C2 may make multiple passes through the heat exchanger 102. Further, the primary and secondary cooling fluids C1, C2 may be arranged in any suitable flow configuration at the heat exchanger, such as a cross-flow, a parallel flow, a counter-flow, or any combination thereof.

In an embodiment, the secondary heat exchanger 170 is configured as a cooling coil and the primary cooling fluid C1 provided to secondary heat exchanger 170 is configured to absorb heat from the secondary cooling fluid C2. During operation, the at least one fan 52 provides a flow of the secondary cooling fluid C2, such as ambient air for example, to the secondary heat exchanger 170. Within the secondary heat exchanger 170, the cool or cold primary cooling fluid C1 absorbs heat from the secondary cooling fluid C2. The primary cooling fluid C1 at both the primary inlet 172 and the primary outlet 174 may be a single phase, such as a liquid for example, such that the primary cooling fluid C1 provided to a heat exchanger 102 is a single phase and is at a temperature capable of absorbing heat from one or more selected heat-generating electronic devices 50. It should be appreciated that the secondary cooling fluid C2 output from the outlet 178 of the secondary heat exchanger 170 may have passed over and therefore absorbed heat from one or more peripheral heat-generating electronic devices 50 prior to reaching a heat removal device 102.

In embodiments of the cooling system 100 that include a secondary heat exchanger 170 mounted upstream from the plurality of heat-generating devices, cooling of the secondary cooling fluid C2 need not be performed at the heat removal devices 102. Accordingly, the heat removal devices 102 mounted in overlapping arrangement with at least one selected heat-generating electronic device 50 need not be heat exchangers. In such embodiments, the cooling of the selected heat-generating devices 50 may be performed primarily by the flow of the primary cooling fluid C1 through the heat removal device 102.

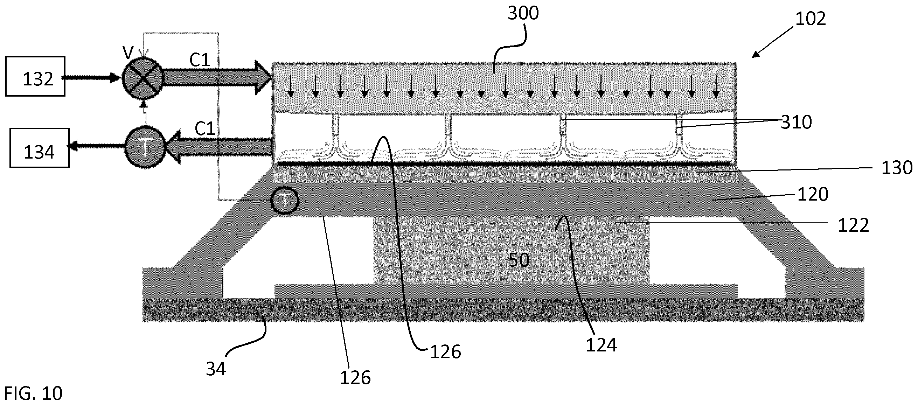

With reference to FIG. 10, an example of another heat removal device 102 suitable for use in the cooling system 100 in combination with the secondary heat exchanger 170 is illustrated. As shown, the heat removal device 102 includes an inlet area 300 and at least one jet impingement feature 310, and in some embodiments a plurality of jet impingement features 310, fluidly coupled to the inlet area 300. Similar to the heat exchanger 102 previously described herein, the outlet end of the jet impingement features 310 is aimed at a surface of the heat removal device 102 thermally coupled to at least one selected heat-generating electronic device 50, such as a bottom surface 312 of the heat removal device 102 for example. The jet impingement configurations may be a free surface type or submerged type or confined-submerged type. Furthermore, the j et flow issued from the jet impingement features 310 may be of any geometrical shape in the cross-section such as circular, polygonal, star-shaped etc.

A cooling system 100 as illustrated and described herein provides an easily scalable solution for cooling heat-generating components. Such a cooling solution can improve the sustainability and efficiency of the heat-generating components by rejecting the heat absorbed from the heat-generating component to a downstream heating application. In addition, the air conditioning load for cooling an area containing a data center is reduced. The cooling system 100 may have a reduced cost compared to existing single phase liquid cooling systems.

The term "about" is intended to include the degree of error associated with measurement of the particular quantity based upon the equipment available at the time of filing the application.

The terminology used herein is for the purpose of describing particular embodiments only. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present invention has been described with reference to an exemplary embodiment or embodiments, it will be understood by those skilled in the art that various changes may be made and equivalents may be substituted for elements of the embodiments without departing from the scope of the present invention, which is defined by the claims. In addition, many modifications may be made to adapt a particular situation or material to the teachings of the present invention. Therefore, it is intended that the present invention not be limited to the particular embodiment disclosed, but that the present invention will include all embodiments falling within the scope of the claims.

## Claims

1. A cooling system (100) for cooling an assembly including at least one heat-generating electronic device (50), the cooling system comprising:
a heat spreader thermally (120) coupled to the at least one heat-generating electronic device; and
a heat removal device (102) including a surface (128) that is thermally couplable to the at least one heat-generating electronic device via the heat spreader, the heat removal device including an inlet area (106; 300) and at least one jet impingement feature (110; 310) fluidly coupled to the inlet area, wherein the at least one jet impingement feature is positioned to direct a primary cooling fluid (C1) toward the surface that is thermally coupled to the at least one heat-generating electronic device.

2. The cooling system of claim 1, wherein the heat removal device includes a heat exchanger (102) having an outlet header (108), the surface that is thermally coupled to the at least one heat-generating electronic device being arranged within the outlet header, wherein the primary cooling fluid and a secondary cooling fluid are arranged in a heat transfer relationship within the at least one heat exchanger.

3. The cooling system of claim 2 wherein the heat exchanger further comprises:
an inlet header (106), the inlet area being defined by the inlet header; and
a plurality of heat exchange tubes (104) extending between the inlet header and the outlet header, the at least one jet impingement feature being separate from and fluidly coupled to the plurality of heat exchange tubes, or the at least one jet impingement feature being integral with at least one of the plurality of heat exchange tubes.

4. The cooling system of any of the preceding claims, further comprising a fluid movement device operable to move the secondary cooling fluid through the heat removal device, optionally wherein the fluid movement device is a fan and the secondary cooling fluid is air.

5. The cooling system of any of the preceding claims, wherein the heat removal device further comprises a plurality of heat exchangers, each of the plurality of heat exchangers being located at and thermally coupled to a respective heat-generating electronic device, optionally wherein at least some of the plurality of heat exchangers are arranged in series relative to a flow of the primary cooling fluid, and/or wherein at least some of the plurality of heat exchangers are arranged in parallel relative to a flow of the primary cooling fluid.

6. The cooling system of any of the preceding claims, further comprising a secondary heat exchanger located upstream from the heat removal device relative to a flow of the primary cooling fluid, optionally wherein the secondary heat exchanger is arranged upstream from the heat removal device relative to a flow of the secondary cooling fluid.

7. The cooling system of any of the preceding claims, wherein the primary cooling fluid provided to the heat removal device is a single phase liquid.

8. A method of cooling an assembly including at least one heat-generating electronic device (50) and at least one peripheral heat-generating device, the method comprising:
cooling a secondary cooling fluid (C2) via a primary cooling fluid (C1);
flowing the cooled secondary cooling fluid over the at least one peripheral heat-generating device; and
expelling the primary cooling fluid at a surface (128) of a heat removal device (102) thermally coupled to the at least one heat-generating electronic device via at least one jet impingement feature (110; 310) to cool the at least one heat-generating electronic device.

9. The method of claim 8, wherein the heat removal device is a heat exchanger (102) and cooling the secondary cooling fluid via the primary cooling fluid occurs within a plurality of heat exchanger tubes of the heat exchanger.

10. The method of claim 8 or 9, further comprising providing the secondary cooling fluid to the heat removal device via a fluid movement device.

11. The method of any claims 8-10, further comprising providing the primary cooling fluid to a secondary heat exchanger, the secondary heat exchanger being located upstream from the heat removal device relative to a flow of the primary cooling fluid.

12. The method of claim 11, further comprising cooling the primary cooling fluid within the secondary heat exchanger.

13. The method of any claims 8-12, further comprising providing the primary cooling fluid to another heat removal device located at and thermally coupled to the at least one heat-generating electronic device, the another heat removal device being arranged downstream from and in series with the heat removal device relative to a flow of the primary cooling fluid.

14. The method of any of claims 8-12, further comprising providing the primary cooling fluid to another heat removal device located at and thermally coupled to the at least one heat-generating electronic device, the another heat removal device being arranged in parallel with the heat removal device relative to a flow of the primary cooling fluid.

15. A cooling system (100) for cooling an assembly including at least one heat-generating electronic device (50), the cooling system comprising:
a heat removal device (102) including a surface that is thermally couplable to the at least one heat-generating electronic device, the heat removal device including an inlet area (106; 300) and at least one jet impingement feature (110;310) fluidly coupled to the inlet area, wherein the at least one jet impingement feature is positioned to direct a primary cooling fluid (C1) toward the surface that is thermally coupled to the at least one heat-generating electronic device;
wherein the primary cooling fluid when provided to the inlet area is a single phase.
